(19) Europäisches Patentamt
European Patent Office
Office européen des brevets

(11) **EP 4 173 122 B1**

(12) **EUROPÄISCHE PATENTSCHRIFT**

(45) Veröffentlichungstag und Bekanntmachung des Hinweises auf die Patenterteilung:
**03.07.2024 Patentblatt 2024/27**

(21) Anmeldenummer: **21797950.9**

(22) Anmeldetag: **12.10.2021**

(51) Internationale Patentklassifikation (IPC):
*H02K 11/20* (2016.01)     *G01R 31/34* (2020.01)

(52) Gemeinsame Patentklassifikation (CPC):
**G01R 31/343; H02K 11/20**

(86) Internationale Anmeldenummer:
**PCT/EP2021/078085**

(87) Internationale Veröffentlichungsnummer:
**WO 2022/096233 (12.05.2022 Gazette 2022/19)**

(54) **VERFAHREN ZUM ÜBERWACHEN DES BETRIEBES EINER ANTRIEBSTECHNISCHEN KOMPONENTE, VORRICHTUNG UND VERWENDUNG**

METHOD FOR MONITORING THE OPERATION OF A DRIVE COMPONENT, APPARATUS AND USE

PROCÉDÉ POUR SURVEILLER LE FONCTIONNEMENT D'UN COMPOSANT D'ENTRAÎNEMENT, DISPOSITIF ET UTILISATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.11.2020 EP 20206216**

(43) Veröffentlichungstag der Anmeldung:
**03.05.2023 Patentblatt 2023/18**

(73) Patentinhaber: **Siemens Aktiengesellschaft**
**80333 München (DE)**

(72) Erfinder: **SEWIOLO, Benjamin**
**90587 Obermichelbach (DE)**

(74) Vertreter: **Siemens Patent Attorneys**
**Postfach 22 16 34**
**80506 München (DE)**

(56) Entgegenhaltungen:
EP-A1- 3 322 088     EP-A1- 3 404 810
EP-A1- 3 499 710     EP-A2- 2 650 667
DE-A1-102018 103 428     DE-A1-102018 110 554
DE-U1-202019 101 047

## Beschreibung

Die Erfindung betrifft ein Verfahren zum Überwachen des Betriebes einer antriebstechnischen Komponente.

Ferner betrifft die Erfindung eine Steuereinheit mit Mitteln zur Durchführung eines derartigen Verfahrens.

Darüber hinaus betrifft die Erfindung ein Computerprogramm zur Durchführung eines derartigen Verfahrens bei Ablauf in einer Steuereinheit.

Des Weiteren betrifft die Erfindung die Verwendung einer in einem mobilen Endgerät integrierten Spule zum Erfassen einer elektromagnetischen Größe.

Zudem betrifft die Erfindung eine Vorrichtung zum Überwachen des Betriebes einer antriebstechnischen Komponente.

Ein derartiges Verfahren zum Überwachen des Betriebes einer antriebstechnischen Komponente wird beispielsweise in einem industriellen Umfeld mit zahlreichen automatisierten Prozessen eingesetzt, um Wartungsintervalle zu koordinieren oder bei Bedarf frühzeitig Gegenmaßnahmen einzuleiten. Eine derartige antriebstechnische Komponente ist beispielsweise eine elektrische rotierende Maschine, insbesondere ein Motor oder ein Generator, oder ein Stromrichter, insbesondere ein Gleichrichter, ein Wechselrichter, ein Umrichter oder ein Gleichspannungswandler. Die Ermittlung derartiger Zustandsgrößen erfordert in der Regel einen hohen messtechnischen Aufwand. Ein derartiges Überwachungsverfahren soll jedoch ohne konstruktive Änderungen an der antriebstechnischen Komponente durchführbar sein, um den eigentlichen Betrieb nicht zu beeinflussen. Ferner soll ein zusätzlicher Hardwareaufwand für das Überwachungsverfahren minimiert werden.

Die Offenlegungsschrift EP 3 499 710 A1 beschreibt ein Verfahren zum Überwachen des Betriebes einer elektrischen rotierenden Maschine, insbesondere einer Asynchronmaschine, mit einem Rotor, einem Stator und einem Maschinengehäuse, in dem der Rotor und der Stator aufgenommen sind. Damit das Überwachungsverfahren möglichst einfach und ohne konstruktive Änderungen an der elektrischen rotierenden Maschine durchführbar ist, wird vorgeschlagen, dass eine Schlupffrequenz und eine Synchronfrequenz durch Erfassung eines magnetischen Streufeldes außerhalb des Maschinengehäuses ermittelt werden, wobei aus der Schlupffrequenz und der Synchronfrequenz ein Drehmoment und/oder eine Läuferdrehfrequenz ermittelt werden.

Die Offenlegungsschrift EP 3 404 810 A1 beschreibt ein Verfahren zum Überwachen des Betriebes einer elektrischen rotierenden Maschine mit einem Rotor, einem Stator und einem Maschinengehäuse, in dem der Rotor und der Stator aufgenommen sind. Um ohne konstruktive Änderungen, im Vergleich zum Stand der Technik, eine höhere Zuverlässigkeit zu erreichen, wird vorgeschlagen, dass auf einer äußeren Oberfläche des Maschinengehäuses zumindest eine äußere Temperatur an zumindest einer bekannten Position erfasst wird, wobei aus der erfassten äußeren Temperatur mittels eines in einer Cloud bereitgestellten Temperaturmodells zumindest eine innere Temperatur ermittelt wird.

Die Offenlegungsschrift EP 2 650 667 A2 beschreibt eine Vorrichtung zum Analysieren eines Motorstatus in einem mobilen Endgerät umfassend: eine erste Erkennungseinheit, die so konfiguriert ist, dass sie Vibrationen eines damit in Kontakt stehenden Motors erkennt und die Vibrationen an eine Steuerung liefert; eine zweite Erkennungseinheit, die so konfiguriert ist, dass sie das Geräusch des Motors erkennt und das Geräusch an die Steuerung liefert; und eine Steuerung, die so konfiguriert ist, dass sie eine Frequenz aus den Vibrationen und dem Geräusch des Motors analysiert, um eine Änderung der Vibrationen zu überprüfen und so ein Analyseergebnis über einen Status des Motors zu erhalten.

Die Offenlegungsschrift DE 10 2018 103 428 A1 beschreibt ein System zum Kommunizieren mit einem Motor, welches eine NFC-Antenne, gekoppelt mit einer Motoranordnung und konfiguriert, Signale von einem Motorsteuergerät zu empfangen, enthält. Die NFC-Antenne ist konfiguriert, ein Magnetfeld mit einer ausgewählten Frequenz auszugeben. Das System enthält ferner eine Kommunikationsschnittstelle, konfiguriert, die Signale von der NFC-Antenne an ein Handgerät weiterzugeben.

Die Offenlegungsschrift DE 10 2018 110 554 A1 beschreibt einen Magnetfeldkoppler zum Koppeln eines RFID-Systems.

Die Offenlegungsschrift EP 3 322 088 A1 beschreibt ein Verfahren zum Überwachen des Betriebes einer elektrischen rotierenden Maschine.

Der Erfindung liegt die Aufgabe zugrunde, ein Verfahren zum Überwachen des Betriebes einer antriebstechnischen Komponente anzugeben, das mit minimalem zusätzlichen Hardwareaufwand durchführbar ist.

Die Aufgabe wird erfindungsgemäß durch ein Verfahren zum Überwachen des Betriebes einer antriebstechnischen Komponente mittels einer in einem mobilen Endgerät integrierten Spule gelöst, wobei das Verfahren folgende Schritte umfasst: Erfassen einer elektromagnetischen Größe der antriebstechnischen Komponente außerhalb eines Gehäuses der antriebstechnischen Komponente mittels der integrierten Spule, Ermitteln zumindest einer ersten Frequenz anhand der erfassten elektromagnetischen Größe und Ermitteln einer ersten Zustandsgröße der antriebstechnischen Komponente aus der zumindest einen ersten Frequenz.

Darüber hinaus wird die Aufgabe erfindungsgemäß durch eine Steuereinheit mit Mitteln zur Durchführung eines derartigen Verfahrens gelöst.

Ferner wird die Aufgabe erfindungsgemäß durch ein Computerprogramm zur Durchführung eines derartigen Verfahrens bei Ablauf in einer Steuereinheit gelöst.

Überdies wird die Aufgabe erfindungsgemäß durch die Verwendung einer in einem mobilen Endgerät integrierten Spule zum Erfassen einer elektromagnetischen Größe einer antriebstechnischen Komponente gelöst.

Des Weiteren wird die Aufgabe erfindungsgemäß durch eine Vorrichtung zum Überwachen des Betriebes einer antriebstechnischen Komponente gelöst, wobei die Vorrichtung folgende Komponenten umfasst: eine in einem mobilen Endgerät integrierte Spule, welche zum Erfassen einer elektromagnetische Größe der antriebstechnischen Komponente außerhalb eines Gehäuses der antriebstechnischen Komponente konfiguriert ist und eine Auswerteeinheit, welche zum Ermitteln zumindest einer ersten Frequenz anhand der erfassten elektromagnetischen Größe und zum Ermitteln einer ersten Zustandsgröße der antriebstechnischen Komponente aus der zumindest einen ersten Frequenz konfiguriert ist.

Die in Bezug auf das Verfahren nachstehend angeführten Vorteile und bevorzugten Ausgestaltungen lassen sich sinngemäß auf die Steuereinheit, das Computerprogramm, die Verwendung und die Vorrichtung übertragen.

Der Erfindung liegt die Überlegung zugrunde, durch Verwendung einer in einem mobilen Endgerät, insbesondere einem Smartphone oder einem Tablet, integrierten Spule einen zusätzlichen Hardwareaufwand für eine Überwachung des Betriebes einer antriebstechnischen Komponente zu minimieren. Eine derartige integrierte Spule ist beispielsweise innerhalb eines Gehäuses des mobilen Endgeräts angeordnet und/oder unlösbar mit dem mobilen Endgerät verbunden. Insbesondere ist eine derartige integrierte Spule bereits ab Werk im mobilen Endgerät vorhanden und zum kontaktlosen Laden des mobilen Endgeräts, beispielsweise nach dem Qi-Standard, konfiguriert. Beispielsweise ist die integrierte Spule als planare Luftspule ausgeführt. Eine Minimierung des Hardwareaufwands bedeutet, dass zusätzliche, insbesondere dedizierte, Hardware für die Überwachung des Betriebes einer antriebstechnischen Komponente auf ein Minimum reduziert wird. In diesem Zusammenhang bedeutet "dedizierte Hardware" zur Überwachung, dass diese ausschließlich für diesen Zweck konfiguriert ist. Eine derartige antriebstechnische Komponente ist beispielsweise eine elektrische rotierende Maschine, insbesondere ein Motor oder ein Generator, oder ein Stromrichter, insbesondere ein Gleichrichter, ein Wechselrichter, ein Umrichter oder ein Gleichspannungswandler. Bei der Überwachung des Betriebes der antriebstechnischen Komponente wird das mobile Endgerät zum Erfassen einer elektromagnetischen Größe außerhalb eines Gehäuses der antriebstechnischen Komponente, insbesondere im Bereich eines magnetischen Streufeldes, angeordnet. Beispielsweise wird die integrierte Spule durch Auflegen des mobilen Endgeräts auf dem Gehäuse im magnetischen Streufeld der antriebstechnischen Komponente positioniert. Die elektromagnetische Größe ist insbesondere ein Strom, der, beispielsweise durch ein elektromagnetisches Wechselfeld der antriebstechnischen Komponente, in die integrierte Spule induziert wird. Insbesondere wird die elektromagnetische Größe vor einem Gleichrichter im mobilen Endgerät abgegriffen. Beispielsweise wird ein bereits vorhandenes Signal ausgewertet.

Daraufhin wird anhand der erfassten elektromagnetischen Größe zumindest eine erste Frequenz ermittelt. Die Ermittlung der zumindest einen ersten Frequenz erfolgt beispielsweise durch Abtastung und anschließende digitale Signalverarbeitung. Anschließend wird aus der zumindest einen ersten Frequenz eine erste Zustandsgröße der antriebstechnischen Komponente ermittelt. Eine derartige Zustandsgröße ist beispielsweise eine Information über einen Betriebszustand der antriebstechnischen Komponente, insbesondere ob und/oder mit welcher Frequenz die antriebstechnischen Komponente betrieben wird.

Die Ermittlung der zumindest einen ersten Frequenz und anschließend der ersten Zustandsgröße erfolgt beispielsweise in einer zentralen IT-Infrastruktur. Eine zentrale IT-Infrastruktur ist beispielsweise mindestens ein lokales Computersystem oder eine cloud-basierte IT-Plattform. In der zentralen IT-Infrastruktur werden Speicherplatz, Rechenleistung und/oder Anwendungssoftware bereitgestellt. Das mobile Endgerät ist, insbesondere kontaktlos über Bluetooth oder WLAN, mit der der zentralen IT-Infrastruktur verbunden. Ein Computerprogramm zur Durchführung eines Überwachungsverfahrens ist beispielsweise als App auf dem mobilen Endgerät ausgeführt. Eine Steuereinheit, welche insbesondere Teil des mobilen Endgeräts ist, weist Mittel zur Durchführung des Überwachungsverfahrens auf, welche beispielswiese einen digitalen Logikbaustein, insbesondere einen Mikroprozessor, einen Mikrocontroller oder einen ASIC (application-specific integrated circuit) umfassen. Die Verwendung der im mobilen Endgerät integrierten Spule ermöglicht eine Überwachung des Betriebes einer antriebstechnischen Komponente ohne dass konstruktive Änderungen an der antriebstechnischen Komponente selbst durchzuführen sind. Ferner ist keine dedizierte Hardware für das Überwachungsverfahren erforderlich, sodass der Hardwareaufwand minimiert ist.

Eine weitere Ausführungsform sieht vor, dass zumindest das Ermitteln der ersten Frequenz mittels einer Auswerteeinheit des mobilen Endgeräts durchgeführt wird, welche mit der integrierten Spule verbunden ist. Eine derartige Auswerteeinheit ist beispielsweise ein digitaler Logikbaustein, insbesondere ein Mikroprozessor, ein Mikrocontroller oder ein ASIC. Da die Auswerteeinheit ebenfalls Teil des mobilen Endgeräts ist, wird der Hardwareaufwand zusätzlich reduziert und das Überwachungsverfahren vereinfacht.

Eine weitere Ausführungsform sieht vor, dass das Ermitteln der zumindest einen ersten Frequenz unter Verwendung einer Fast-Fourier-Transformation erfolgt. Durch eine Fast-Fourier-Transformation sind Frequenzen im Spektrum leicht identifizierbar und mit hoher Genauigkeit analysierbar. Insbesondere durch Mittelung bei der Fast-Fourier-Transformation wird eine Analyse auch bei einem sehr geringen Signalpegel der zu untersuchenden Frequenz ermöglicht.

Eine weitere Ausführungsform sieht vor, dass die antriebstechnische Komponente eine elektrische rotierende Maschine, insbesondere eine Asynchronmaschine, mit einem Rotor und einem Stator ist, wobei der Rotor und der Stator in dem Gehäuse aufgenommen sind und wobei das Erfassen der elektromagnetischen Größe außerhalb des Gehäuses der elektrischen rotierenden Maschine erfolgt. Beispielsweise wird mit der integrierten Spule ein äußeres Streufeld des Stators gemessen aus dessen, insbesondere periodischer, zeitlicher Änderung eine Statorfrequenz ermittelt wird, aus welcher ein Betriebszustand der elektrischen rotierenden Maschine ableitbar ist. Die Ermittlung eines Betriebszustandes der elektrischen rotierenden Maschine über die Statorfrequenz mit Hilfe der integrierten Spule des mobilen Endgeräts ist einfach und kostengünstig zu realisieren.

Eine weitere Ausführungsform sieht folgende weitere Schritte vor: Erfassen einer zusätzlichen physikalischen Größe der antriebstechnischen Komponente mittels eines im mobilen Endgerät integrierten Sensors, Ermitteln zumindest einer zweiten Frequenz anhand der erfassten weitere physikalischen Größe, Ermitteln einer zweiten Zustandsgröße der antriebstechnischen Komponente aus der zumindest einen ersten Frequenz und der zumindest einen zweiten Frequenz. Beispielsweise umfassen die zumindest eine erste Frequenz eine Statorfrequenz und die zumindest eine zweite Frequenz eine Rotorfrequenz einer Asynchronmaschine. Die ermittelte zweite Zustandsgröße ist beispielsweise ein abgegebenes Drehmoment einer Asynchronmaschine, welches aus der Statorfrequenz und der Rotorfrequenz ermittelbar ist. Die Ermittlung einer derartigen zweiten Zustandsgröße ist einfach und präzise implementierbar.

Eine weitere Ausführungsform sieht vor, dass das Erfassen der zusätzlichen physikalischen Größe durch Messen einer Vibration und/oder eines akustischen Signals erfolgt. Insbesondere weist der integrierte Sensor einen Beschleunigungssensor und/oder einen akustischen Sensor auf. Die Messung einer Vibration und/oder eines akustischen Signals erfolgt im Wesentlichen kontaktlos außerhalb des Maschinengehäuses, sodass keine konstruktiven Änderungen erforderlich sind. Insbesondere sind ein Beschleunigungssensor und/oder ein akustischer Sensor in der Regel Teil eines mobilen Endgeräts, wie einem Smartphone oder Tablet, sodass keine dedizierte Hardware erforderlich und somit der Hardwareaufwand minimiert ist.

Im Folgenden wird die Erfindung anhand der in den Figuren dargestellten Ausführungsbeispiele näher beschrieben und erläutert.

Es zeigen:

FIG 1 eine schematische Darstellung einer elektrischen rotierenden Maschine mit einer ersten Ausführungsform einer Überwachungsvorrichtung,

FIG 2 eine schematische Darstellung einer elektrischen rotierenden Maschine mit einer zweiten Ausführungsform einer Überwachungsvorrichtung,

FIG 3 ein Ablaufdiagramm einer ersten Ausführungsform eines Verfahrens zum Überwachen des Betriebes einer antriebstechnischen Komponente,

FIG 4 eine schematische Darstellung einer elektrischen rotierenden Maschine mit einer dritten Ausführungsform einer Überwachungsvorrichtung und

FIG 5 ein Ablaufdiagramm einer zweiten Ausführungsform eines Verfahrens zum Überwachen des Betriebes einer antriebstechnischen Komponente.

Bei dem im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

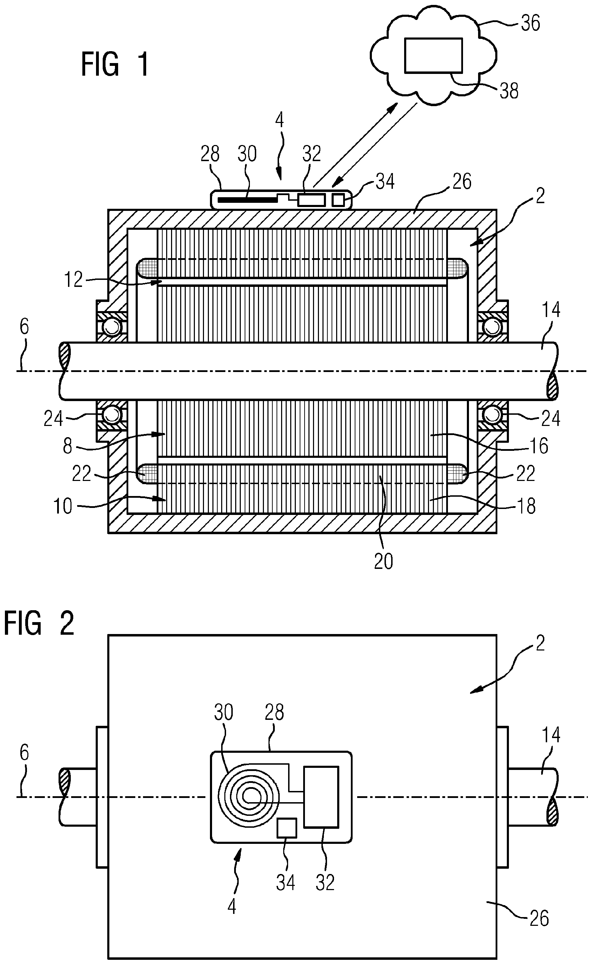

FIG 1 zeigt eine schematische Darstellung einer elektrischen rotierenden Maschine 2 mit einer ersten Ausführungsform einer Überwachungsvorrichtung 4. Die elektrische rotierende Maschine 2 ist beispielsweise als Asynchronmaschine ausgeführt und weist einen um eine Rotationsachse 6 rotierbaren Rotor 8 und einen den Rotor 8 umgebenden Stator 10 auf, wobei sich zwischen dem Rotor 8 und dem Stator 10 ein Spalt 12, der insbesondere als Luftspalt ausgeführt ist, befindet. Die Rotationsachse 6 definiert eine Axialrichtung und eine Radialrichtung. Der Rotor 8 umfasst eine Welle 14 und ein Rotorblechpaket 16. Der Stator 10 umfasst ein Statorblechpaket 18 mit Statorwicklungen 20, wobei das Statorblechpaket 18 aus einer Vielzahl von geschichteten Elektroblechen aufgebaut ist. Die Statorwicklungen 20 verlaufen in Axialrichtung durch das Statorblechpaket 18 und bilden an seinen axialen Enden Wickelköpfe 22 aus. Die Welle 14 des Rotors 8 ist über Lager 24 gelagert. Der Rotor 8 und der Stator 10 sind in einem geschlossenen Gehäuse 26 untergebracht.

Die Überwachungsvorrichtung 4 umfasst ein mobiles Endgerät 28, welches beispielhaft auf dem Gehäuse 26 der elektrischen rotierenden Maschine 2 aufliegt. Alternativ liegt das mobile Endgerät 28 auf dem Gehäuse 26 einer anderen antriebstechnischen Komponente, beispielsweise eines Stromrichters, auf. Das mobile Endgerät 28 ist als Smart Device, beispielsweise als ein Smartphone oder Tablet, ausgeführt, welches eine integrierte Spule 30 aufweist. Eine integrierte Spule 30 ist innerhalb eines Gehäuses des mobilen Endgeräts 28 angeordnet und/oder unlösbar mit dem mobilen Endgerät 28 verbunden. Insbesondere ist die integrierte Spule 30 bereits ab Werk im mobilen Endgerät 28 vorhanden und zum kontaktlosen Laden des mobile Endgeräts 28, beispielsweise nach dem Qi-Standard, konfiguriert. Die zum kontaktlosen Laden des mobile Endgeräts 28 konfigurierte integrierte Spule 30 ist insbesondere als planare Luftspule ausgeführt, welche z.B. eine Induktivität im Bereich von 1 μH bis 200 μH aufweist.

Die im mobilen Endgerät 28 integrierte Spule 30 ist zum Erfassen einer elektromagnetischen Größe außerhalb des Gehäuses 26 der elektrischen rotierenden Maschine 2 konfiguriert. Durch Auflegen des mobilen Endgeräts 28 auf dem Gehäuse 26 ist die integrierte Spule 30 beispielsweise in einem magnetischen Streufeld der elektrischen rotierenden Maschine 2 angeordnet, wodurch die elektromagnetische Größe erfassbar ist. Die elektromagnetische Größe ist insbesondere ein Strom, der durch ein elektromagnetisches Wechselfeld der elektrischen rotierenden Maschine 2 in die integrierte Spule 30 induziert wird.

Die integrierte Spule 30 ist mit einer Auswerteeinheit 32 verbunden, wobei die Auswerteeinheit 32 Bestandteil des mobilen Endgeräts 28 ist. Die Auswerteeinheit 32 des mobilen Endgeräts 28 ist zur Ermittlung zumindest einer ersten Frequenz anhand der erfassten elektromagnetischen Größe konfiguriert. Die zumindest eine erste Frequenz umfasst beispielsweise eine Statorfrequenz. Ferner ist die Auswerteeinheit 32 zum Ermitteln einer ersten Zustandsgröße der antriebstechnischen Komponente aus der zumindest einen ersten Frequenz konfiguriert. Eine derartige Zustandsgröße ist beispielsweise eine Information über einen Betriebszustand der elektrischen rotierenden Maschine 2, insbesondere ob und/oder mit welcher Frequenz die elektrische rotierende Maschine 2 betrieben wird. Darüber hinaus weist das mobile Endgerät 28 eine Steuereinheit 34 auf, welche ebenfalls Bestandteil des mobilen Endgeräts 28 ist.

Das mobile Endgerät 28 ist, insbesondere kontaktlos, mit einer zentralen IT-Infrastruktur 36 verbunden. Die Verbindung wird beispielsweise über Bluetooth oder WLAN hergestellt. Eine zentrale IT-Infrastruktur 36 ist beispielsweise mindestens ein lokales Computersystem oder eine cloud-basierte IT-Plattform. In der zentralen IT-Infrastruktur 36 werden Speicherplatz, Rechenleistung und/oder Anwendungssoftware bereitgestellt. Beispielsweise umfasst die zentrale IT-Infrastruktur 36 eine zentrale Auswerteeinheit 38, welche beispielsweise zur Ermittlung der ersten Zustandsgröße herangezogen wird. Optional ist zumindest ein Teil der Steuereinheit 34 der zentralen IT-Infrastruktur 36 zugewiesen und/oder die zentrale IT-Infrastruktur 36 weist einen Digitalen Zwilling, auch Digital Twin genannt, auf, welcher zur Ermittlung der ersten Zustandsgröße herangezogen wird. Ein derartiger Digitaler Zwilling ist beispielsweise in der Offenlegungsschrift US 2017/0286572 A1 beschrieben. Der Offenbarungsgehalt von US 2017/0286572 A1 wird durch Verweisung in die vorliegende Anmeldung mit einbezogen.

FIG 2 zeigt eine schematische Darstellung einer elektrischen rotierenden Maschine 2 mit einer zweiten Ausführungsform einer Überwachungsvorrichtung 4, wobei das mobile Endgerät 28, welches die integrierte Spule 30, die Auswerteeinheit 32 und die Steuereinheit 34 umfasst, auf der elektrischen rotierenden Maschine 2 aufliegt. Die Auswerteeinheit 32 ist zum Ermitteln zumindest einer ersten Frequenz anhand der erfassten elektromagnetischen Größe und zum Ermitteln einer ersten Zustandsgröße der elektrischen rotierenden Maschine 2 aus der zumindest einen ersten Frequenz konfiguriert. Die Auswerteeinheit 32 ist Teil des mobilen Endgeräts 28. Alternativ ist eine externe Auswerteeinheit, beispielsweise über ein Kabel, einen Draht oder eine Schaltvorrichtung, mit der integrierten Spule 30 verbunden, welche zur Ermittlung der zumindest einen ersten Frequenz und zur Ermittlung der ersten Zustandsgröße konfiguriert ist. Eine derartige externe Auswerteeinheit ist beispielweise als ein Mikrocontroller oder ein anderer programmierbarer Logikbaustein ausgeführt. Insbesondere wird die elektromagnetische Größe B vor einem Gleichrichter im mobilen Endgerät 28 abgegriffen. Beispielsweise wird ein bereits vorhandenes Signal ausgewertet. Sollte eine Signalstärke, beispielsweise durch die Filterwirkung der integrierten Spule 30, schwach sein, ist die zumindest eine erste Frequenz durch Korrelation ermittelbar. Die weitere Ausführung der elektrischen rotierenden Maschine 2 mit der Überwachungsvorrichtung 4 in FIG 2 entspricht der in FIG 1.

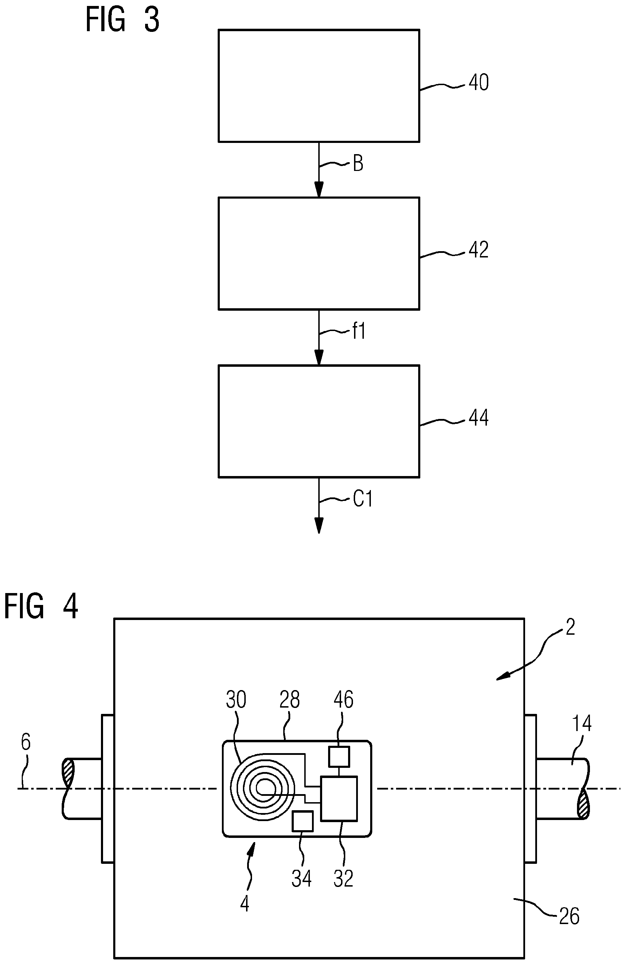

FIG 3 zeigt ein Ablaufdiagramm einer ersten Ausführungsform eines Verfahrens zum Überwachen des Betriebes einer antriebstechnischen Komponente. Das Überwachungsverfahren beinhaltet das Erfassen 40 einer elektromagnetischen Größe B außerhalb eines Gehäuses 26 einer antriebstechnischen Komponente mittels einer integrierten Spule 30. Die antriebstechnische Komponente ist beispielsweise als eine elektrische rotierende Maschine 2 oder als ein Stromrichter ausgeführt. Die elektromagnetischen Größe B ist insbesondere ein Strom, welcher durch Anordnen des mobilen Endgeräts 28 im Bereich eines Streufeldes der antriebstechnischen Komponente in die integrierte Spule 30 induziert wird.

Das Überwachungsverfahren beinhaltet ferner das Ermitteln 42 zumindest einer ersten Frequenz f1 anhand der erfassten elektromagnetischen Größe B. Das Ermitteln 42 der zumindest einen ersten Frequenz (f1) erfolgt insbesondere unter Verwendung einer Fast-Fourier-Transformation. Die zumindest eine erste Frequenz f1 umfasst beispielsweise eine Statorfrequenz einer elektrischen rotierenden Maschine oder eine Frequenz eines Stromrichters.

Das Überwachungsverfahren beinhaltet darüber hinaus das Ermitteln 44 einer ersten Zustandsgröße C1 der antriebstechnischen Komponente aus der zumindest einen ersten Frequenz (f1). Eine derartige Zustandsgröße ist beispielsweise eine Information über einen Betriebszustand der antriebstechnischen Komponente, insbesondere ob und/oder mit welcher Frequenz die antriebs-technische Komponente betrieben wird.

FIG 4 zeigt eine schematische Darstellung einer elektrischen rotierenden Maschine 2 mit einer dritten Ausführungsform einer Überwachungsvorrichtung 4. Das mobile Endgerät 28 umfasst einen im mobilen Endgerät 28 integrierten Sensor 46, welcher zum Erfassen einer zusätzlichen physikalischen Größe der antriebstechnischen Komponente konfiguriert ist. Insbesondere weist der Sensor 46 einen akustischen Sensor und/oder einen Beschleunigungssensor auf. Die zusätzliche physikalische Grö-ße ist beispielsweise ein akustisches Signal und/oder ein Beschleunigungssignal. Insbesondere durch Auflegen des mobilen Endgeräts 28 wird durch den Beschleunigungssensor eine Vibration der elektrischen rotierenden Maschine 2 erfasst.

Die Auswerteeinheit 32 des mobilen Endgeräts 28 ist zum Ermitteln zumindest einer zweiten Frequenz anhand der erfassten zusätzlichen physikalischen Größe konfiguriert. Beispielsweise ist aus dem erfassten akustischen Signal und/oder dem Beschleunigungssignal eine Rotorfrequenz der elektrischen rotierenden Maschine 2 ermittelbar. Die weitere Ausführung der elektrischen rotierenden Maschine 2 mit der Überwachungsvorrichtung 4 in FIG 4 entspricht der in FIG 2.

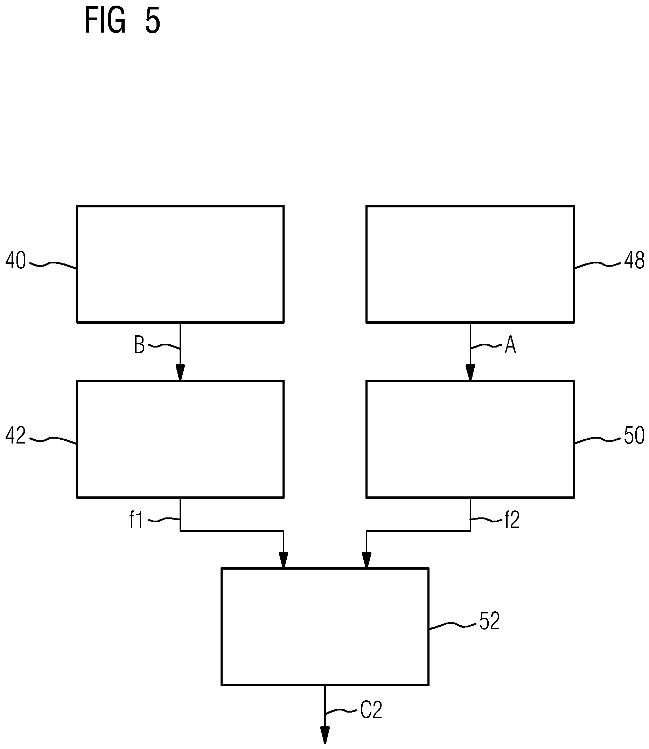

FIG 5 zeigt ein Ablaufdiagramm einer zweiten Ausführungsform eines Verfahrens zum Überwachen des Betriebes einer antriebstechnischen Komponente. Das Überwachungsverfahren beinhaltet das Erfassen 48 einer zusätzlichen physikalischen Größe A der antriebstechnischen Komponente mittels eines im mobilen Endgerät 28 integrierten Sensors 46. Die zusätzliche physikalischen Größe A ist insbesondere ein akustisches Signal, welches beispielsweise von einem akustischen Sensor erfasst wird, und/oder ein Beschleunigungssignal, welches beispielsweise von einem Beschleunigungssensor erfasst wird.

Das Überwachungsverfahren beinhaltet ferner das Ermitteln 50 zumindest einer zweiten Frequenz f2 anhand der erfassten weiteren physikalischen Größe A. Das Ermitteln 50 der zumindest einen zweiten Frequenz f2 erfolgt insbesondere unter Verwendung einer Fast-Fourier-Transformation. Die zumindest eine zweite Frequenz f2 umfasst beispielsweise eine Rotorfrequenz einer elektrischen rotierenden Maschine.

Das Erfassen 40 der ersten elektromagnetischen Größe B und die Ermittlung 42 der zumindest einen ersten Frequenz f1 erfolgt gemäß dem Ablaufdiagramm in FIG 3. Das Überwachungsverfahren beinhaltet darüber hinaus das Ermitteln 52 einer zweiten Zustandsgröße C2 der antriebstechnischen Komponente aus der zumindest einen ersten Frequenz f1 und der zumindest einen zweiten Frequenz f2. Die ermittelte zweite Zustandsgrö-ße C2 ist beispielsweise ein abgegebenes Drehmoment M einer Asynchronmaschine. Hierzu wird eine Schlupffrequenz fΔ der Asynchronmaschine aus einer Statorfrequenz und einer Rotorfrequenz ermittelt. Aus der Schlupffrequenz fΔ und der Statorfrequenz fs, welche auch Synchronfrequenz genannt wird, wird beispielsweise ein auf die Statorfrequenz fs bezogener Schlupf S berechnet:

$$ S = \frac{f\Delta}{fs}. $$

Ein aktuelles von der Asynchronmaschine abgegebenes Drehmoment M wird aus dem Schlupf S, beispielsweise nach der Kloß'schen Formel, errechnet:

$$ M = M_k \cdot \frac{2}{\frac{S}{S_K} + \frac{S_K}{S}}, $$

wobei $M_k$ das Kippmoment und $S_K$ den Kippschlupf bezeichnen. Das Kippmoment $M_k$ und der Kippschlupf $S_K$ sind motorspezifische Kenngrößen, welche z.B. über eine App bereitstellbar sind.

Zusammenfassend betrifft die Erfindung ein Verfahren zum Überwachen des Betriebes einer antriebstechnischen Komponente. Um einen zusätzlichen Hardwareaufwand zu minimieren, wird vorgeschlagen, dass das Überwachungsverfahren mittels einer in einem mobilen Endgerät 28 integrierten Spule 30 durchgeführt wird, welches folgende Schritte umfasst: Erfassen einer elektromagnetischen Größe B außerhalb eines Gehäuses 18 der antriebstechnischen Komponente mittels der integrierten Spule 30, Ermitteln 42 zumindest einer ersten Frequenz f1 anhand der erfassten elektromagnetischen Größe B und Ermitteln 44 einer ersten Zustandsgröße C1 der antriebstechnischen Komponente aus der zumindest einen ersten Frequenz f1.

**Patentansprüche**

1. Verfahren zum Überwachen des Betriebes einer antriebstechnischen Komponente mittels einer in einem mobilen Endgerät (28) integrierten Spule (30),

wobei die antriebstechnische Komponente eine elektrische rotierende Maschine (2) mit einem Rotor (8) und einem Stator (10) ist und der Rotor (8) und der Stator (10) in einem Gehäuse (26) aufgenommen sind, **gekennzeichnet dadurch, daß** die Spule (30) zum kontaktlosen Laden des mobilen Endgeräts, insbesondere nach dem Qi-Standard, konfiguriert ist, und durch die Schritte:

- Erfassen (40) einer elektromagnetischen Größe (B) der antriebstechnischen Komponente außerhalb des Gehäuses (26) der antriebstechnischen Komponente mittels der integrierten Spule (30),
- Ermitteln (42) zumindest einer ersten Frequenz (f1) anhand der erfassten elektromagnetischen Größe (B),
wobei die erste Frequenz eine Statorfrequenz (fs) umfasst,
- Ermitteln (44) einer ersten Zustandsgröße (C1) der antriebstechnischen Komponente aus der zumindest einen ersten Frequenz (f1),

wobei das Erfassen der elektromagnetischen Größe (B) außerhalb des Gehäuses (26) der elektrischen rotierenden Maschine (2) erfolgt wobei ein Streufeld des Stators (10) gemessen wird, wobei aus dessen, insbesondere periodischer, zeitlicher Änderung die Statorfrequenz (fs) ermittelt wird.

2. Verfahren nach Anspruch 1,
wobei die elektromagnetische Größe (B) ein Strom ist, der durch ein elektromagnetisches Wechselfeld der antriebstechnischen Komponente in die integrierte Spule (30) induziert wird.

3. Verfahren nach einem der vorherigen Ansprüche,
wobei mit der integrierten Spule (30) ein äußeres Streufeld der antriebstechnischen Komponente erfasst wird.

4. Verfahren nach einem der vorherigen Ansprüche,
wobei zumindest das Ermitteln (42) der ersten Frequenz (f1) mittels einer Auswerteeinheit (32) des mobilen Endgeräts (28) durchgeführt wird, welche mit der integrierten Spule (30) verbunden ist.

5. Verfahren nach einem der vorherigen Ansprüche,
wobei das Ermitteln (42) der zumindest einen ersten Frequenz (f1) unter Verwendung einer Fast-Fourier-Transformation erfolgt.

6. Verfahren nach einem der vorherigen Ansprüche,
wobei die antriebstechnische Komponente eine Asynchronmaschine ist.

7. Verfahren nach einem der vorherigen Ansprüche,
wobei mit Hilfe der Statorfrequenz (fs) ein Betriebszustand der elektrischen rotierenden Maschine (2) ermittelt wird.

8. Verfahren nach einem der vorherigen Ansprüche, umfassend folgende weitere Schritte:

- Erfassen (48) einer zusätzlichen physikalischen Größe (A) der antriebstechnischen Komponente mittels eines im mobilen Endgerät (28) integrierten Sensors (46),
- Ermitteln (50) zumindest einer zweiten Frequenz (f2) anhand der erfassten weitere physikalischen Größe (A),
- Ermitteln (52) einer zweiten Zustandsgröße (C2) der antriebstechnischen Komponente aus der zumindest einen ersten Frequenz (f1) und der zumindest einen zweiten Frequenz (f2).

9. Verfahren nach Anspruch 8,
wobei das Erfassen der zusätzlichen physikalischen Größe (A) durch Messen einer Vibration und/oder eines akustischen Signals erfolgt.

10. Steuereinheit (34) mit Mitteln zur Durchführung eines Verfahrens nach einem der vorherigen Ansprüche.

11. Computerprogramm zur Durchführung eines Verfahrens nach einem der Ansprüche 1 bis 9 bei Ablauf in einer Steuereinheit (34) nach Anspruch 10.

12. Verwendung einer in einem mobilen Endgerät (28) integrierten Spule (30), welche zum kontaktlosen Laden des mobilen Endgeräts, insbesondere nach dem Qi-Standard, konfiguriert ist, zum Erfassen einer elektromagnetischen Größe (B) einer antriebstechnischen Komponente,

wobei die antriebstechnische Komponente eine elektrische rotierende Maschine (2) mit einem Rotor (8) und einem Stator (10) ist,
wobei der Rotor (8) und der Stator (10) in einem Gehäuse (26) aufgenommen sind,
wobei die elektromagnetische Größe (B) in einem Streufeld des Stators (10) außerhalb des Gehäuses (26) der elektrischen rotierenden Maschine (2) gemessen wird,
wobei aus der, insbesondere periodischen, zeitlichen Änderung des Streufeldes eine Statorfrequenz (fs) ermittelt wird.

13. Verwendung nach Anspruch 12,
wobei eine Auswerteeinheit (32) des mobilen Endgeräts (28) dazu verwendet wird, zumindest eine erste Frequenz (f1) anhand der erfassten elektromagnetischen Größe (B) zu ermitteln.

14. Vorrichtung (4) zum Überwachen des Betriebes einer antriebstechnischen Komponente, wobei die antriebstechnische Komponente eine elektrische rotierende Maschine (2) mit einem Rotor (8) und einem Stator (10) ist, wobei der Rotor (8) und der Stator (10) in einem Gehäuse (26) aufgenommen sind, **gekennzeichnet durch:**

- eine in einem mobilen Endgerät (28) integrierte Spule (30), welche zum kontaktlosen Laden des mobilen Endgeräts, insbesondere nach dem Qi-Standard, konfiguriert ist und welche zum Erfassen einer elektromagnetischen Grö-ße (B) der antriebstechnischen Komponente außerhalb eines Gehäuses (18) der antriebstechnischen Komponente konfiguriert ist,
- eine Auswerteeinheit (32),

welche zum Ermitteln zumindest einer ersten Frequenz (f1), welche eine Statorfrequenz (fs) umfasst, anhand der erfassten elektromagnetischen Größe (B) und zum Ermitteln einer ersten Zustandsgröße (C1) der antriebstechnischen Komponente aus der zumindest einen ersten Frequenz (f1) konfiguriert ist,

wobei die integrierte Spule (30) zum Erfassen einer zeitlichen Änderung eines Streufeldes der elektrischen rotierenden Maschine (2) konfiguriert ist.

15. Vorrichtung (4) nach Anspruch 14,
wobei die Auswerteeinheit (32) Teil des mobilen Endgeräts (28) ist.

16. Vorrichtung (4) nach einem der Ansprüche 14 oder 15,
wobei die integrierte Spule (30) zum Erfassen eines Stromes, der durch ein elektromagnetisches Wechselfeld der antriebstechnischen Komponente in die integrierte Spule (30) induziert wird, konfiguriert ist.

17. Vorrichtung (4) nach einem der Ansprüche 14 bis 16,
wobei die Auswerteeinheit (32) zumindest teilweise einer zentralen IT-Infrastruktur (36) zugewiesen ist.

18. Vorrichtung (4) nach einem der Ansprüche 14 bis 17, umfassend einen im mobilen Endgerät (28) integrierten Sensor (46), welcher zum Erfassen einer zusätzlichen physikalischen Größe (A) der antriebstechnischen Komponente konfiguriert ist,

wobei die Auswerteeinheit (32) des mobilen Endgeräts (28) zum Ermitteln zumindest einer zweiten Frequenz (f2) anhand der erfassten zusätzlichen physikalischen Größe (A) und zum Ermitteln einer zweiten Zustandsgröße (C2) der antriebstechnischen Komponente aus der zumindest einen ersten Frequenz (f1) und der zumindest einen zweiten Frequenz (f2) konfiguriert ist.

19. Vorrichtung (4) nach Anspruch 18,
wobei der integrierte Sensor (46) einen Beschleunigungssensor und/oder einen akustischen Sensor aufweist.

## Claims

1. Method for monitoring the operation of a drive component by means of a coil (30) which is integrated in a mobile terminal (28),

wherein the drive component is an electric rotating machine (2) having a rotor (8) and a stator (10) and the rotor (8) and the stator (10) are accommodated in a housing (26), **characterised in that** the coil (30) is configured for contactless charging of the mobile terminal, in particular using the Qi standard,
and **characterised by** the steps:

- capturing (40) an electromagnetic variable (B) of the drive component outside the housing (26) of the drive component by means of the integrated coil (30),
- determining (42) at least one first frequency (f1) on the basis of the captured electromagnetic variable (B), wherein the first frequency comprises a stator frequency (fs),
- determining (44) a first status variable (C1) of the drive component from the at least one first frequency (f1),

wherein the capture of the electromagnetic variable (B) takes place outside the housing (26) of the electric rotating machine (2)
wherein a flux leakage field of the stator (10) is measured, wherein the stator frequency (fs) is determined from the temporal and in particular periodical change of said flux leakage field.

2. Method according to claim 1,
wherein the electromagnetic variable (B) is a current which is induced in the integrated coil (30) by an electromagnetic alternating field of the drive component.

3. Method according to one of the preceding claims,
wherein an external flux leakage field of the drive component is captured by the integrated coil (30).

4. Method according to one of the preceding claims,
wherein at least the determination (42) of the first frequency (f1) is performed by means of an evaluation unit (32) of the mobile terminal (28), said evaluation unit (32) being connected to the integrated coil (30).

5. Method according to one of the preceding claims, wherein the determination (42) of the at least one first frequency (f1) takes place using a fast Fourier transform.

6. Method according to one of the preceding claims, wherein the drive component is an asynchronous machine.

7. Method according to one of the preceding claims, wherein an operating status of the electric rotating machine (2) is determined with the aid of the stator frequency (fs).

8. Method according to one of the preceding claims, comprising further steps as follows:

- capturing (48) an additional physical variable (A) of the drive component by means of a sensor (46) which is integrated in the mobile terminal (28),
- determining (50) at least one second frequency (f2) on the basis of the captured further physical variable (A),
- determining (52) a second status variable (C2) of the drive component from the at least one first frequency (f1) and the at least one second frequency (f2).

9. Method according to claim 8, wherein the capture of the additional physical variable (A) is effected by measuring a vibration and/or an acoustic signal.

10. Control unit (34) having means for performing a method according to one of the preceding claims.

11. Computer program for performing a method according to one of claims 1 to 9 when executed in a control unit (34) according to claim 10.

12. Use of a coil (30), which is integrated in a mobile terminal (28) and which is configured for contactless charging of the mobile terminal, in particular using the Qi standard, for capturing an electromagnetic variable (B) of a drive component,

wherein the drive component is an electric rotating machine (2) having a rotor (8) and a stator (10),
wherein the rotor (8) and the stator (10) are accommodated in a housing (26),
wherein the electromagnetic variable (B) is measured in a flux leakage field of the stator (10) outside the housing (26) of the electric rotating machine (2),

wherein a stator frequency (fs) is determined from the temporal and in particular periodical change of the flux leakage field.

13. Use according to claim 12, wherein an evaluation unit (32) of the mobile terminal (28) is used to determine at least one first frequency (f1) on the basis of the captured electromagnetic variable (B).

14. Device (4) for monitoring the operation of a drive component, wherein the drive component is an electric rotating machine (2) having a rotor (8) and a stator (10), wherein the rotor (8) and the stator (10) are accommodated in a housing (26), **characterised by**:

- a coil (30) which is integrated in a mobile terminal (28) and is configured for contactless charging of the mobile terminal, in particular using the Qi standard, and which is configured to capture an electromagnetic variable (B) of the drive component outside a housing (18) of the drive component,
- an evaluation unit (32),

which is configured to determine at least one first frequency (f1), which comprises a stator frequency (fs), on the basis of the captured electromagnetic variable (B) and to determine a first status variable (C1) of the drive component from the at least one first frequency (f1),

wherein the integrated coil (30) is configured to capture a temporal change of a flux leakage field of the electric rotating machine (2).

15. Device (4) according to claim 14, wherein the evaluation unit (32) is part of the mobile terminal (28).

16. Device (4) according to one of claims 14 or 15, wherein the integrated coil (30) is configured to capture a current which is induced in the integrated coil (30) by an electromagnetic alternating field of the drive component.

17. Device (4) according to one of claims 14 to 16, wherein the evaluation unit (32) is assigned at least partially to a central IT infrastructure (36).

18. Device (4) according to one of claims 14 to 17, comprising a sensor (46) which is integrated in the mobile terminal (28) and is configured to capture an additional physical variable (A) of the drive component,

wherein the evaluation unit (32) of the mobile terminal (28) is configured to determine at least one second frequency (f2) on the basis of the captured additional physical variable (A) and to determine a second status variable (C2) of the drive component from the at least one first frequency (f1) and the at least one second frequency (f2).

19. Device (4) according to claim 18, wherein the integrated sensor (46) has an acceleration sensor and/or an acoustic sensor.

## Revendications

1. Procédé de contrôle du fonctionnement d'un composant de la technique d'entraînement, au moyen d'une bobine (30) intégrée dans un terminal (28) mobile,

   dans lequel le composant de la technique d'entraînement est une machine (2) électrique tournante ayant un rotor (8) et un stator (10) et le rotor (8) et le stator (10) sont logés dans une carcasse (26), **caractérisé en ce que** la bobine (30) est configurée pour la charge sans contact du terminal mobile, en particulier suivant la norme Qi,
   et par les stades :

   - détection (40), au moyen de la bobine (30) intégrée, d'une grandeur (B) électromagnétique du composant de la technique d'entraînement à l'extérieur de la carcasse (26) du composant de la technique d'entraînement,
   - détermination (42) d'au moins une première fréquence (f1) à l'aide de la grandeur (B) électromagnétique détectée, dans lequel la première fréquence comprend une fréquence (fs) statorique,
   - détermination (44) d'une première grandeur (C1) d'état du composant de la technique d'entraînement, à partir de la au moins une première fréquence (f1),

   dans lequel la détection de la grandeur (B) électromagnétique s'effectue à l'extérieur de la carcasse (26) de la machine (2) électrique tournante,
   dans lequel on mesure un champ de dispersion du stator (10), dans lequel à partir de sa variation dans le temps, en particulier périodique, on détermine la fréquence (fs) statorique.

2. Procédé suivant la revendication 1, dans lequel la grandeur (B) électromagnétique est un courant que l'on induit dans la bobine (30) intégrée par un champ alternatif électromagnétique du composant de la technique d'entraînement.

3. Procédé suivant l'une des revendications précédentes, dans lequel on détecte, par la bobine (30) intégrée, un champ de dispersion extérieur du composant de la technique d'entraînement.

4. Procédé suivant l'une des revendications précédentes, dans lequel on effectue au moins la détermination (42) de la première fréquence (f1), au moyen d'une unité (32) d'évaluation du terminal (28) mobile, qui est reliée à la bobine (30) intégrée.

5. Procédé suivant l'une des revendications précédentes, dans lequel on effectue la détermination (42) de la au moins une première fréquence (f1) en utilisant une transformation de Fourier rapide.

6. Procédé suivant l'une des revendications précédentes, dans lequel le composant de la technique d'entraînement est une machine asynchrone.

7. Procédé suivant l'une des revendications précédentes, dans lequel à l'aide de la fréquence (fs) statorique, on détermine un état de fonctionnement de la machine (2) électrique tournante.

8. Procédé suivant l'une des revendications précédentes, comprenant les autres stades suivants :

   - détection (48) d'une grandeur (A) physique supplémentaire du composant de la technique d'entraînement, au moyen d'un capteur (46) intégré dans le terminal (28) mobile,
   - détermination (50) d'au moins une deuxième fréquence (f2) à l'aide de l'autre grandeur (A) physique détectée,
   - détermination (52) d'une deuxième grandeur (C2) d'état du composant de la technique d'entraînement, à partir de la au moins une première fréquence (f1) et de la au moins une deuxième fréquence (f2).

9. Procédé suivant la revendication 8, dans lequel on effectue la détection de la grandeur (A) physique supplémentaire en mesurant une vibration et/ou un signal acoustique.

10. Unité (34) de commande ayant des moyens pour effectuer un procédé suivant l'une des revendications précédentes.

11. Programme d'ordinateur pour effectuer un procédé suivant l'une des revendications 1 à 9, lorsqu'il se déroule dans une unité (34) de commande suivant la revendication 10.

12. Utilisation d'une bobine (30), qui est intégrée dans un terminal (28) mobile et qui est configurée pour la charge sans contact du terminal mobile, en particulier suivant la norme Qi, pour la détection d'une grandeur (B) électromagnétique d'un composant de la technique d'entraînement,

> dans laquelle le composant de la technique d'entraînement est une machine (2) électrique tournante ayant un rotor (8) et un stator (10), dans laquelle le rotor (8) et le stator (10) sont logés dans une carcasse (26), dans laquelle on mesure la grandeur (B) électromagnétique dans un champ de dispersion du stator (10) à l'extérieur de la carcasse (26) de la machine (2) électrique tournante, dans laquelle on détermine une fréquence (fs) statorique à partir de la variation dans le temps, en particulier périodique, du champ de dispersion.

13. Utilisation suivant la revendication 12, dans laquelle on utilise une unité (32) d'évaluation du terminal (28) mobile pour déterminer au moins une première fréquence (f1) à l'aide de la grandeur (B) électromagnétique détectée.

14. Installation (4) de contrôle du fonctionnement d'un composant de la technique d'entraînement,

> dans laquelle le composant de la technique d'entraînement est une machine (2) électrique tournante ayant un rotor (8) et un stator (10), dans laquelle le rotor (8) et le stator (10) sont logés dans une carcasse (26), **caractérisée par** :
>
> - une bobine (30), qui est intégrée au terminal (28) mobile, qui est configurée pour la charge sans contact du terminal mobile, en particulier suivant la norme Qi, et qui est configurée pour la détection d'une grandeur (B) électromagnétique du composant de la technique d'entraînement à l'extérieur d'une carcasse (18) du composant de la technique d'entraînement,
> - une unité (32) d'évaluation, qui est configurée pour déterminer, à l'aide de la grandeur (B) électromagnétique détectée, au moins une première fréquence (f1), qui comprend une fréquence (fs) statorique et, pour déterminer une première grandeur (C1) d'état du composant de la technique d'entraînement à partir de la au moins une première fréquence (f1),

> dans laquelle la bobine (30) intégrée est configurée pour la détection d'une variation, en fonction du temps, d'un champ de dispersion de la machine (2) électrique tournante.

15. Installation (4) suivant la revendication 14, dans laquelle l'unité (32) d'évaluation fait partie du terminal (28) mobile.

16. Installation (4) suivant l'une des revendications 14 ou 15, dans laquelle la bobine (30) intégrée est configurée pour la détection d'un courant que l'on induit dans la bobine (30) intégrée par un champ alternatif électromagnétique du composant de la technique d'entraînement.

17. Installation (4) suivant l'une des revendications 14 à 16, dans laquelle l'unité (32) d'évaluation est affectée au moins en partie à une infrastructure (36) IT centrale.

18. Installation (4) suivant l'une des revendications 14 à 17, comprenant un capteur (46) qui est intégré dans le terminal (28) mobile, et qui est configuré par la détection d'une grandeur (A) physique supplémentaire du composant de la technique d'entraînement, dans laquelle l'unité (32) d'évaluation du terminal (28) mobile est configurée pour la détection d'au moins une deuxième fréquence (f2), à l'aide de la grandeur (A) physique supplémentaire détectée, et pour la détection d'une deuxième grandeur (C2) d'état du composant de la technique d'entraînement, à partir de la au moins une première fréquence (f1) et de la au moins une deuxième fréquence (f2).

19. Installation (4) suivant la revendication 18, dans laquelle le capteur (46) intégré comporte un capteur d'accélération et/ou un capteur acoustique.

FIG 1

FIG 2

FIG 3

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3499710 A1
- EP 3404810 A1
- EP 2650667 A2
- DE 102018103428 A1
- DE 102018110554 A1
- EP 3322088 A1
- US 20170286572 A1